# EUROPÄISCHE PATENTSCHRIFT

(11) **EP 3 817 205 B1**
(45) Veröffentlichungstag und Bekanntmachung des Hinweises auf die Patenterteilung: **12.06.2024**
(21) Anmeldenummer: 19205873.3
(22) Anmeldetag: 29.10.2019
(51) Int. Cl.: H02M 1/10, G01R 19/00, G01R 23/00, H02M 1/32, H02M 3/335

(54) **SCHALTUNGSANORDNUNG ZUM AUSWERTEN EINER EINGANGSSPANNUNG EINER STROMVERSORGUNG UND ZUGEHÖRIGES VERFAHREN**
CIRCUIT ARRANGEMENT FOR EVALUATING AN INPUT VOLTAGE OF A POWER SUPPLY AND ASSOCIATED METHOD
AGENCEMENT DE CIRCUIT PERMETTANT D'ÉVALUER UNE TENSION D'ENTRÉE D'UNE ALIMENTATION ÉLECTRIQUE ET PROCÉDÉ ASSOCIÉ

(43) Veröffentlichungstag der Anmeldung: 05.05.2021
(73) Patentinhaber: Siemens Aktiengesellschaft, 80333 München (DE)
(72) Erfinder: Portisch, Daniel, 2170 Kleinhadersdorf (AT)
(74) Vertreter: Siemens Patent Attorneys

(56) Entgegenhaltungen:
- WO-A1-2015/157857
- CN-A- 102 299 617
- GB-A- 2 493 450
- JP-A- H0 682 487

## Beschreibung

### Technisches Gebiet

Die gegenständliche Erfindung betrifft allgemein das Gebiet der Elektrotechnik, insbesondere den Bereich der Leistungselektronik sowie leistungselektronischer Schaltungen. Im Speziellen bezieht sich die vorliegende Erfindung auf eine Schaltungsanordnung, von welcher eine Eingangsspannung einer Stromversorgung bzw. eines Schaltnetzteils ausgewertet wird - d.h. es werden ein Wert der Eingangsspannung der Stromversorgung ermittelt und eine jeweilige Spannungsart der Eingangsspannung ermittelt. Weiterhin betrifft die gegenständliche Erfindung ein zugehöriges Verfahren zum Auswerten der Eingangsspannung der Stromversorgung.

### Stand der Technik

In der Fertigungs- und Automatisierungstechnik werden in gro-ßem Umfang Stromversorgungen bzw. Schaltnetzteile für eine Versorgung von Verbrauchern wie z.B. elektronische Steuerungen, Pumpen, Ventilen, Sensoren, etc. eingesetzt. Diese Verbraucher werden von der Stromversorgung bzw. dem Schaltnetzteil mit einer geeigneten, oft vordefinierten Spannung versorgt. Typischerweise wird dazu ein eingangsseitig hohes Spannungsniveau, wie z.B. eine 230V-Wechselspannung oder eine 120V-Wechselspannung, auf ein für die Verbraucher vordefiniertes, niedrigeres und üblicherweise konstantes Spannungsniveau (z.B. 24V Gleichspannung als Nennausgangsspannung und 28V Gleichspannung als maximale Ausgangsspannung) auf einer Ausgangsseite der Stromversorgung umgesetzt.

Die Stromversorgung bzw. das Schaltnetzteil wird üblicherweise mit einer Netzspannung als Eingangsspannung aus einem einphasigen oder dreiphasigen Versorgungsnetz, insbesondere einem Drehstromnetz, versorgt. Eine einphasige Stromversorgung kann z.B. mit einer Wechselspannung (z.B. 230V-Wechselspannung) als Eingangsspannung gespeist, welche üblicherweise als Differenz zwischen einem so genannten Außenleiter und einem so genannten Neutralleiter des Versorgungsnetzes abfällt. Daher ist bei einer solchen Stromversorgung häufig eine Eingangsstufe - beispielsweise in Form einer Gleichrichtereinheit - vorgesehen, durch welche die Wechselspannung aus dem Versorgungsnetz in eine Gleichspannung für die Stromversorgung umgewandelt wird. Von der Stromversorgung bzw. dem Schaltnetzteil wird die meist unstabilisierte Eingangsspannung dann in eine konstante Ausgangsspannung bzw. in die vordefinierte Versorgungsspannung für die elektrischen Verbraucher umgesetzt, wobei eine Konstanz der Ausgangsspannung und/oder eines Ausgangsstroms durch eine Regelung des Energieflusses erreicht wird.

Die Konstanz der Ausgangsspannung führt beispielsweise dazu, dass bei einer sinkenden Eingangsspannung ein Eingangsstrom der Stromversorgung zu steigen beginnt. Dies kann z.B. zur Erwärmung der Bauteile der Stromversorgung bzw. des Schaltnetzteils oder sogar zu einer Beschädigung führen. Daher wird üblicherweise aus Sicherheitsgründen die Eingangsspannung der Stromversorgung überwacht und gegebenenfalls der Ausgang der Stromversorgung abgeschaltet, wenn z.B. ein vorgegebener Wert von der Eingangsspannung unterschritten wird. Um ein Überhitzen bzw. eine Beschädigung der Stromversorgung, vor allem der einphasigen Stromversorgung, aufgrund einer eingangsseitigen Unterspannung bzw. einer Unterspannung aus dem Versorgungsnetz zu verhindern, ist eine laufende und möglichst genaue Messung der Eingangsspannung der Stromversorgung z.B. mittels einer eigenen Messschaltung notwendig, von welcher z.B. ein primärseitiges Bezugspotential bzw. Massepotential der Stromversorgung verwendet wird.

Die Messung der Eingangsspannung kann beispielsweise mittels einer Einweggleichrichtung der Eingangsspannung, bei welcher z.B. jeweils für den Außenleiter und den Neutralleiter der Versorgungsspannung eine Diode vorgesehen ist, und mittels eines ohmschen Spannungsteilers erfolgen. Diese Messvariante der Eingangsspannung weist allerdings den Nachteil auf, dass beispielsweise bei Leerlauf bzw. bei einer Teillast an der Ausgangsseite der Stromversorgung bzw. des Schaltnetzteil von den so genannten Y-Kondensatoren ein kapazitiver Spannungsteiler gebildet wird. Die so genannten Y-Kondensatoren dienen der Elektronmagnetischen Verträglichkeit (EMV), um ungewollte wechselseitige Beeinflussung anderer Geräte zu verhindern. Sie sind zwischen Außenleiter bzw. Neutralleiter und Schutzleiter oder Protective Earth (PE) angebracht. Durch den von den Y-Kondensatoren gebildeten kapazitiven Spannungsteiler wird beispielsweise das primärseitige Bezugs- bzw. Massepotential beeinflusst und die Messung der Eingangsspannung kann damit sehr ungenau werden.

Weiterhin kann mit dieser Messvariante z.B. auch nicht die Spannungsart der Eingangsspannung festgestellt werden. Bei einer von einer Spannungsquelle oder einem Versorgungsnetz gelieferten elektrischen Spannung können als Spannungsart Gleichspannung und Wechselspannung unterschieden werden. Eine Gleichspannung ist eine elektrische Spannung, deren Augenblickswert sich über einen längeren Betrachtungszeitraum kaum bzw. gar nicht ändert. D.h. sie hat zu jedem Zeitpunkt dasselbe Vorzeichen und (annähernd) denselben Betrag. Als Wechselspannung wird eine elektrische Spannung bezeichnet, deren Polarität in regelmäßiger Wiederholung wechselt, deren zeitlicher Mittelwert üblicherweise aber null ist.

Eine weitere Variante die Eingangsspannung einer Stromversorgung bzw. eines Schaltnetzteils zu ermitteln, kann beispielsweise über einen Zweiweg-Gleichrichter bzw. Brückengleichrichter, durch welchen die Eingangsspannung gleichgerichtet wird, und mit Hilfe eines Differenzverstärkers, welchem die gleichgerichtete Eingangsspannung zugeführt wird, erfolgen. Diese Messvariante weist allerdings den Nachteil auf, dass die Gleichrichtereinheit für die Messung der Eingangsspannung bei einer netzseitigen Überspannung - einem so genannten Surge - die gleichen Überspannungswerte aushalten muss wie die eingangsseitige Gleichrichtereinheit der Stromversorgung. Dies kann zu einer hohen Belastung für die Eingangsspannungsmessung eingesetzten Bauteile (z.B. Dioden der Gleichrichtereinheit, etc.) führen bzw. diese Bauteile müssen entsprechend ausgelegt sein, um eventuell auftretende Überspannungen aushalten zu können. Eine derartige Dimensionierung kann z.B. zu relativ hohen Kosten und aufgrund der Anzahl und Größe der notwendigen Bauteile zu einem relativ großen Platzbedarf führen.

Beispiele des Stands der Technik, die die oben beschriebenen Anordnungen und Verfahren darstellen, sind die folgenden: GB 2 493 450 A, CN 102299617 A und WO 2015/157857 A1.

### Darstellung der Erfindung

Der Erfindung liegt daher die Aufgabe zugrunde, eine Schaltungsanordnung sowie ein zugehöriges Verfahren anzugeben, mit welchen auf einfache und kostengünstige Weise eine genaue Auswertung einer Eingangsspannung einer Stromversorgung bzw. eines Schaltnetzteils ermöglicht wird.

Diese Aufgabe wird durch eine Schaltungsanordnung sowie durch ein zugehöriges Verfahren gemäß den unabhängigen Ansprüchen gelöst. Vorteilhafte Ausführungsformen der vorliegenden Erfindung sind in den abhängigen Ansprüchen beschrieben.

Die Lösung der angeführten Aufgabe erfolgt erfindungsgemäß durch ein Verfahren zum Ermitteln einer Spannungsart einer Eingangsspannung einer Stromversorgung, insbesondere einer einphasigen Stromversorgung, für welches ein auf der Eingangsspannung der Stromversorgung basierendes erstes Ausgangssignal genutzt wird, welches mittels der erfindungsgemäßen Schaltungsanordnung erfasst wird. Mit Hilfe dieses Verfahrens kann insbesondere eine Spannungsart - d.h. Gleichspannung oder Wechselspannung - der Eingangsspannung aus dem ersten Ausgangssignal der Schaltungsanordnung abgeleitet werden. Dazu wird nach dem Erfassen des ersten Ausgangssignal mit der erfindungsgemäßen Schaltungsanordnung, nach erstmaligem Feststellen bzw. Durchlaufen eines Scheitelwertes des ersten Ausgangssignals abgewartet, bis ein erster Schwellwert unterschritten wird. Danach werden folgende Schritte bis zum Erreichen einer vorgegebenen Anzahl an Wiederholungen durchlaufen:
- Abspeichern eines Zeitstempels und Starten einer vorgegebenen Totzeit (Tₜ), wenn der erste Schwellwert (SW1) vom ersten Ausgangssignal (AS1) unterschritten wird;
- Prüfen, ob nach Ablauf der vorgegebenen Totzeit ein zweiter Schwellwert vom ersten Ausgangssignal überschritten wird; und
- Abwarten bis das erste Ausgangssignal den ersten Schwellwert wieder unterschreitet, wenn bei Ablauf der Totzeit der zweite Schwellwert vom ersten Ausgangssignal überschritten wurde, wobei der zweite Schwellwert größer als der erste Schwellwert ist.
Nach Erreichen der vorgegebenen Anzahl an Wiederholungen wird aus den gespeicherten Zeitstempeln eine Frequenz und die Spannungsart der Eingangsspannung abgeleitet.

Mit Hilfe des erfindungsgemäßen Verfahrens kann auf einfache und robuste Weise ermittelt werden, welche Spannungsart die Eingangsspannung aufweist. Dazu wird beispielsweise aus zumindest zwei gespeicherten Zeitstempeln eine Frequenz der Eingangsspannung abgeleitet. Kann beispielsweise eine Frequenz in einem Bereich von 45 bis 65 Hertz festgestellt werden, so wird dies z.B. als Versorgung mit einer Wechselspannung bewertet. Durch das erfindungsgemäße Verfahren kann idealerweise die Spannungsart der Eingangsspannung selbst bei Störungen der Netz- bzw. Versorgungsspannung, wie z.B. beim Einschalten mit einem kleinen Trenntransformator, etc. erkannt werden.

Es ist weiterhin günstig, wenn das erfindungsgemäße Verfahren abgebrochen wird, wenn nach Ablauf der Totzeit der zweite Schwellwert innerhalb einer vorgebbaren ersten Zeitdauer nicht überschritten wird, oder wenn nach Ablauf einer zweiten vorgebbaren Zeitdauer der erste Schwellwert nicht unterschritten wird. Für die erste Zeitdauer und für die zweite Zeitdauer können z.B. gleiche Werte oder unterschiedliche Werte gewählt werden. Die Messung bzw. die zu wiederholenden Schritte des erfindungsgemäßen Verfahrens können z.B. solange wiederholt werden, bis eine gültige Wechselspannungsversorgung (z.B. 10mal) detektiert wurde. Wird nach der Anzahl vorgegebenen Wiederholungen oder nach Ablauf der ersten bzw. zweiten Zeitdauer (z.B. 100ms) keine gültige Wechselspannung festgestellt, so wird davon ausgegangen, dass als Eingangsspannung einen Gleichspannung (z.B. von einer Batterie) als Versorgungsspannung der Stromversorgung verwendet wird.

Erfindungsgemäß erfolgt die Lösung der Aufgabe weiterhin durch eine Schaltungsanordnung zum Auswerten einer Eingangsspannung. Diese Schaltungsanordnung kann derart angeordnet sein, dass die Eingangsspannung der Stromversorgung an einer Eingangsseite der Schaltungsanordnung abfällt. Diese Schaltungsanordnung umfasst zumindest einen Differenzverstärker, eine erste Gleichrichtereinheit und eine erste Kompensationsdiode. Der Differenzverstärker ist eingerichtet zum Umwandeln der Eingangsspannung in ein Nutzsignal, welches über eine erste Gleichrichtereinheit gleichgerichtet wird. Die erste Gleichrichtereinheit ist an einem Ausgang des Differenzverstärkers angeordnet und es ist ihr einen erste Kompensationsdiode derart zugeordnet, dass eine Flussspannung der ersten Gleichrichtereinheit kompensiert wird. Weiterhin umfasst die Schaltungsanordnung einen Inverter, eine zweite Gleichrichtereinheit und eine zweite Kompensationsdiode. Der Inverter ist eingerichtet zum Erzeugen eines invertierten Nutzsignals aus dem Nutzsignal. Das invertierte Nutzsignal wird mittels einer an einem Ausgang des Inverters angeordneten, zweiten Gleichrichtereinheit gleichgerichtet, wobei der zweiten Gleichrichtereinheit eine zweite Kompensationsdiode derart zugeordnet ist, dass eine Flussspannung der zweiten Gleichrichtereinheit kompensiert wird. Weiterhin umfasst die Schaltungsanordnung einen Mischeinheit, von welcher aus dem gleichgerichteten Nutzsignal und dem gleichgerichteten, invertierten Nutzsignal ein erstes Ausgangssignal erzeugt wird. Weiterhin umfasst die Schaltungsanordnung eine Steuereinheit, die dazu eingerichtet ist, das erfindungsgemäße Verfahren zum Ermitteln der Spannungsart durchzuführen.

Der Hauptaspekt der erfindungsgemäß vorgeschlagenen Lösung besteht darin, auf einfache und kostengünstige Weise eine genaue Auswertung einer Eingangsspannung einer Stromversorgung bzw. eines Schaltnetzteils zu ermöglichen. Dabei wird ein erstes Ausgangssignal erzeugt, auf dessen Basis ein Wert der Eingangsspannung sowie eine Spannungsart der Eingangsspannung (z.B. Gleichspannung oder Wechselspannung) ermittelt werden kann. Durch eine ausgangsseitige Anbringung der Gleichrichtereinheiten, welche z.B. als Gleichrichterdioden ausgestaltet sein können, und damit bei einem niedrigeren Spannungsniveau als auf der Eingangsseite der Schaltungsanordnung können kostengünstigere Bauteile verwendet werden. Durch die den Gleichrichtereinheiten zugeordneten Kompensationsdioden wird einen relativ hohe Flussspannung der jeweiligen Gleichrichtereinheit bzw. der jeweiligen Gleichrichterdiode kompensiert. Dadurch können sehr genaue Messergebnisse - vor allem beim Ermitteln eines Mittelwerts der Eingangsspannung - erzielt werden.

Es ist weiterhin vorteilhaft, wenn die Schaltungsanordnung ausgangsseitig eine Filtereinheit, wie z.B. einen RC-Filter, umfasst, von welcher aus dem ersten Ausgangssignal der Schaltungsanordnung ein zweites Ausgangssignal (z.B. ein Mittelwert des gleichgerichteten Eingangsspannungssignals) erzeugt wird. Auf diese Weise kann aus dem ersten Ausgangssignal die Spannungsart der Eingangsspannung und aus dem zweiten Ausgangssignal ein Messwert der Eingangsspannung ermittelt werden.

Dazu sind idealerweise für eine Auswertung das erste Ausgangssignal und des zweite Ausgangssignal über eine Datenverbindung (z.B. Process Field Network oder kurz Profinet, etc.) an eine Steuereinheit weiterleitbar. Diese Steuereinheit kann z.B. lokal oder zentral angeordnet und beispielsweise als Mikrokontroller ausgeführt sein.

Es ist weiterhin günstig, wenn der Differenzverstärker eingangsseitig hochohmig ausgeführt ist. Dadurch kann auf einfache Weise das relativ hohe Spannungsniveau der Eingangsspannung (z.B. 84V bis 278V) beim erzeugten Nutzsignal auf ein wesentlich niedrigeres Spannungsniveau (z.B. 0,5V bis 12,5V) herabgesetzt werden. Dadurch können insbesondere für die Gleichrichtereinheiten kostengünstigere Bauteile, welche nicht für hohe Spannungen ausgelegt sind, eingesetzt werden.

Es kann sein, dass die erste Gleichrichtereinheit und die zugeordnete erste Kompensationsdiode und dass die zweite Gleichrichtereinheit und die zugeordnete zweite Kompensationsdiode als jeweils Doppeldioden ausgestaltet sind. Dabei sind die jeweilige Gleichrichtereinheit und die jeweilige Kompensationsdiode beispielsweise in einem Gehäuse verbaut und dadurch idealerweise thermisch gekoppelt. Durch diese thermische Kopplung können temperaturabhängige Flussspannungen sehr einfach eliminiert werden und eine relativ genaue Auswertung bzw. Messung der Eingangsspannung erzielt werden.

Es kann sein, dass der Differenzverstärker und der Inverter derart ausgestaltet sind, dass eine interne Hilfsversorgung der Stromversorgung als Betriebsspannung für den Differenzverstärker und für den Inverter genutzt werden kann. Auf dieses Weise ist keine zusätzliche Spannungsversorgung für die Versorgung des Differenzverstärker und des Inverters notwendig. Die Schaltungsanordnung kann damit platz- und kostensparend ausgestaltet werden. Dazu ist weiterhin einen Referenzspannung (z.B. von 5 Volt) vorgesehen, welche eingangsseitig vom Differenzverstärker und vom Inverter als Bezugsspannung genutzt wird. Durch die Referenzspannung wird z.B. eine Ausgangsspannung des Differenzverstärkers bzw. des Inverters durch den entsprechenden Wert der Referenzspannung verschoben. Dadurch kann für die Spannungsversorgung des Differenzverstärkers bzw. des Inverters nur die vorhandene Spannungsquelle sowie ein Bezugs- bzw. Massepotential genutzt werden. Eine negative Spannungsquelle zur Versorgung des Differenzverstärkers bzw. des Inverters kann eingespart werden.

### Kurzbeschreibung der Zeichnung

Die Erfindung wird nachfolgend in beispielhafter Weise anhand der beigefügten Figuren erläutert. Es zeigen dabei:
Figur 1 schematisch und beispielhaft eine Stromversorgung mit der erfindungsgemäßen Schaltungsanordnung zum Auswerten einer Eingangsspannung
Figur 2 schematisch eine beispielhafte Ausführungsform der erfindungsgemäßen Schaltungsanordnung zum Auswerten einer Eingangsspannung einer Stromversorgung
Figur 3 eine beispielhafte, detaillierte Darstellung der erfindungsgemäßen Schaltungsanordnung zum Auswerten einer Eingangsspannung einer Stromversorgung
Figur 4 einen beispielhaften Verlauf eines von der erfindungsgemäßen Schaltungsanordnung generierten, ersten Ausgangssignals mit entsprechender Auswertung

### Ausführung der Erfindung

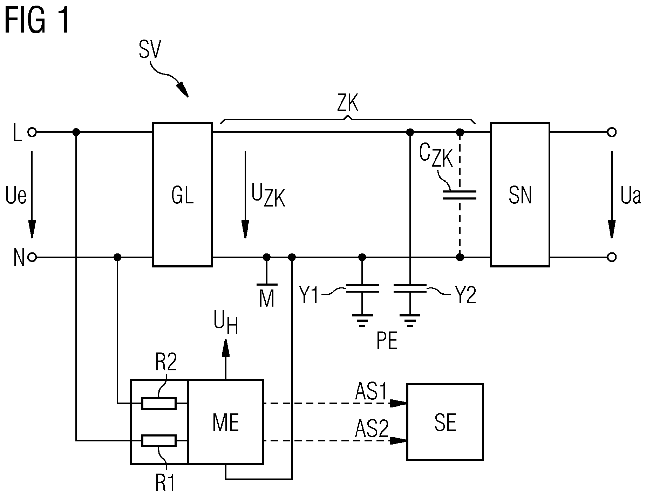

Figur 1 zeigt schematisch und beispielhaft eine einphasige Stromversorgung bzw. ein einphasiges Schaltnetzteil SV, welche die erfindungsgemäße Schaltungsanordnung ME zum Auswerten einer Eingangsspannung Ue der Stromversorgung SV bzw. des Schaltnetzteils SV umfasst. Die beispielshafte Stromversorgung SV wird von einem Versorgungsnetz mit der Eingangsspannung Ue versorgt, welche z.B. von einer Spannungsdifferenz zwischen einem Außenleiter L und dem Neutralleiter N des Versorgungsnetzes gebildet wird. D.h. es wird zur Spannungsversorgung der Stromversorgung SV nur ein Außenleiter L bzw. eine Phase L des Versorgungsnetzes genutzt.

Die Eingangsspannung Ue, welche beispielsweise eine 230V-Wechselspannung sein kann, wird über eine Gleichrichtereinheit GL als Eingangsstufe der Stromversorgung SV in eine gleichgerichtete Zwischenkreisspannung U_{ZK} an einer Ausgangsseite der Gleichrichtereinheit GL bzw. an einer Eingangsseite eines Zwischenkreises ZK umgesetzt. Die Zwischenkreisspannung U_{ZK} ist dabei auf ein Bezugspotential M bzw. ein Massepotential M bezogen. Der Zwischenkreis ZK kann beispielsweise einen optionalen Zwischenkreiskondensator C_{ZK} umfassen. Weiterhin sind im Zwischenkreis ZK z.B. aus Gründen der elektromagnetischen Verträglichkeit zumindest zwei Y-Kondensatoren Y1, Y2 angeschlossen. Über die Y-Kondensatoren Y1, Y2 sind im Zwischenkreis ZK zwischen dem oberen Potential bzw. zwischen dem das Bezugs- oder Massepotential M und einem Schutzleiter PE bzw. der so genannten Protective Earth PE angeordnet.

Von der Stromversorgung SV bzw. dem Schaltnetzteil SV wird die meist unstabilisierte Eingangsspannung Ue in eine konstante Ausgangsspannung Ua (z.B. eine Gleichspannung von 4 bis 28V) an einer Ausgangsseite der Stromversorgung SV bzw. des Schaltnetzteils SV zur Versorgung eines oder mehrerer Verbraucher umgewandelt, wobei eine Konstanz der Ausgangsspannung Ua eine Regelung des Energieflusses erreicht wird. Dazu umfasst die Stromversorgung SV weiterhin einen Schaltwandler SN, welcher an einer Ausgangsseite des Zwischenkreises ZK angeordnet ist. Dieser Schaltwandler SN weist zumindest ein periodisch arbeitendes, elektronisches Schaltelement auf und kann z.B. als potentialtrennende Schaltwandler SN, welche eine galvanische Trennung (z.B. Transformator) aufweisen, oder potentialgebundene (d.h. nicht potentialtrennende) Schaltwandler SN ohne galvanische Trennung ausgeführt sein. An einer Ausgangsseite des Schaltwandlers SN kann dann die konstante Ausgangsspannung Ua abgegriffen werden bzw. einem oder mehreren Verbrauchern zur Verfügung gestellt werden.

Weiterhin weist die Stromversorgung SV die erfindungsgemäße Schaltungsanordnung ME zur Auswertung der Eingangsspannung Ue der Stromversorgung SV bzw. des Schaltnetzteils SV. Die Schaltungsanordnung ME ist dabei derart angeordnet, dass an einem Eingang der Schaltungsanordnung ME die Eingangsspannung Ue der Stromversorgung SV abfällt. Dazu ist die Schaltungsanordnung ME z.B. eingangsseitig über hochohmige Widerstände R1, R2 mit dem Außenleiter L und dem Neutralleiter N an der Eingangsseite des Schaltnetzteils SN verbunden. Für eine Spannungsversorgung der Schaltungsanordnung ME ist eine Hilfsspannung U_{H} (z.B. 13V) vorgesehen. Als Hilfsspannung U_{H} kann beispielsweise einen bereits in der Stromversorgung SV z.B. für Steuer- und/oder Signaleinheiten genutzte Hilfsversorgung genutzt werden. Weiterhin ist die Schaltungsanordnung mit dem Bezugspotential bzw. Massepotential M des Zwischenkreises ZK der Stromversorgung SV verbunden.

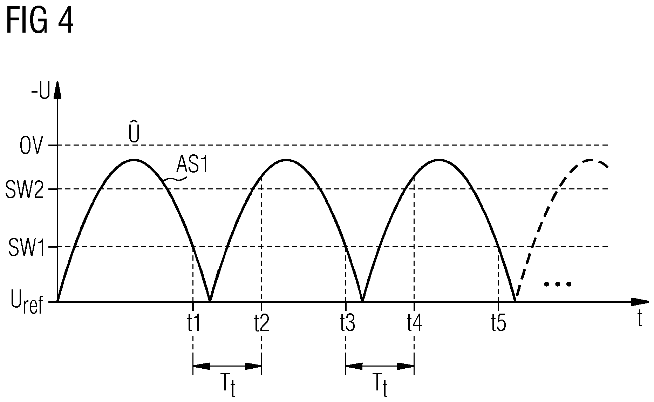

Ausgangsseitig werden von der erfindungsgemäßen Schaltungsanordnung ME zwei Ausgangssignale AS1, AS2 zur Verfügung gestellt. Diese Ausgangssignale AS1, AS2 können beispielsweise über eine Datenverbindung (z.B. Process Field Network oder kurz Profinet, etc.) an eine lokale oder zentrale Steuereinheit SE weitergeleitet werden. Mit Hilfe der Steuereinheit SE, welche z.B. als Mikrocontroller ausgeführt sein kann, können die Ausgangssignale AS1, AS2 entsprechend ausgewertet werden. Aus einem ersten Ausgangssignal AS1 kann beispielsweise mittels des zugehörigen Verfahrens zum Auswerten der Eingangsspannung Ue der Stromversorgung SV eine Spannungsart der Eingangsspannung abgeleitet werden. D.h. aus dem ersten Ausgangssignal AS1 kann - wie in der Folge anhand von Figur 4 näher beschrieben wird - erkannt werden, ob die Eingangsspannung Ue eine Wechselspannung oder eine Gleichspannung ist. Ein zweites Ausgangssignal AS2 kann für eine genaue Messung eines Mittelwerts der Eingangsspannung Ue herangezogen werden.

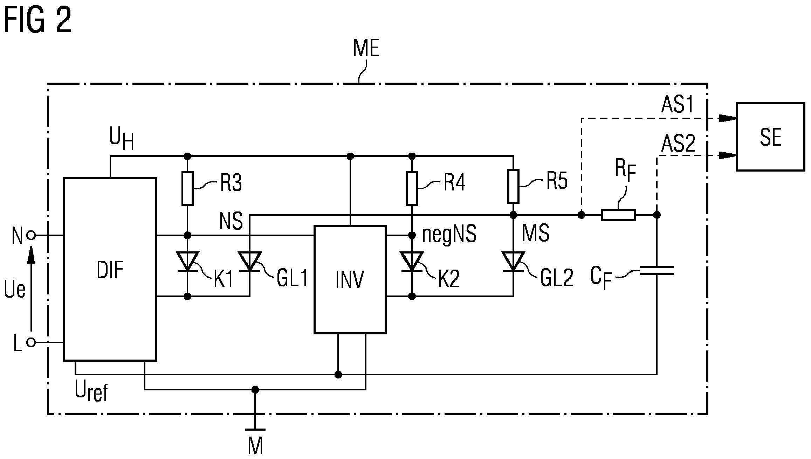

Figur 2 zeigt nun schematisch eine beispielhafte Ausführungsform der erfindungsgemäßen Schaltungsanordnung ME zum Auswerten der Eingangsspannung Ue der Stromversorgung SV, wobei die Schaltungsanordnung derart angeordnet ist, dass die Eingangsspannung Ue der Stromversorgung SV auch an einer Eingangsseite der Schaltungsanordnung ME anliegt. Dazu ist die Eingangsseite der Schaltungsanordnung z.B. an den Außenleiter L und an den Neutralleiter N der einphasigen Spannungsversorgung der Stromversorgung SV bzw. des Schaltnetzteils SV angebunden, wobei als Eingangsspannung Ue die Differenzspannung zwischen Außenleiter L und Neutralleiter N am Eingang der Schaltungsanordnung ME bzw. eines Differenzverstärkers DIF der Schaltungsanordnung ME anliegt. Vom Differenzverstärker DIF wird die Eingangsspannung Ue mit einem relativ hohen Spannungsniveau (z.B. 84 bis 278V) in ein Nutzsignal NS mit niedrigem Spannungsniveau (z.B. 0,5 bis 12,5V) umgewandelt. Der Differenzverstärker DIF ist eingangsseitig hochohmig ausgestaltet.

An einer Ausgangsseite des Differenzverstärkers DIF ist eine erste Gleichrichtereinheit GL1, insbesondere ein Einweggleichrichter GL1 oder eine Gleichrichterdiode GL1, angebracht, von welcher das vom Differenzverstärker DIF erzeugte Nutzsignal NS gleichgerichtet wird und zu einer Mischeinheit MS weitergeführt wird. Der ersten Gleichrichtereinheit GL1 ist eine erste Kompensationsdiode K1 zugeordnet, von welcher eine durch die Flussspannung der ersten Gleichrichtereinheit GL1 verursachte Spannungsverschiebung kompensiert wird. Idealerweise können die erste Gleichrichtereinheit GL1 und die erste Kompensationsdiode K1 als so genannte Doppeldiode ausgestaltet sein. D.h. die beiden Einheiten GL1, K1 sind z.B. in einem gemeinsamen Gehäuse verbaut und dadurch thermisch gekoppelt, wodurch temperaturabhängige Flussspannungen sehr einfach und gut eliminierbar sind.

Der Kompensationsdiode ist weiterhin ein erster Pullup-Widerstand R3 zugeordnet, welcher eine (Signal-)Leitung mit einem höheren Spannungspotential verbindet. Der erste Pullup-Widerstand ist zwischen einer Anode der ersten Kompensationsdiode K1 und einer Hilfsspannung U_{H} angeordnet. Die Hilfsspannung U_{H} (z.B. 13V), welche beispielsweise bereits in der Stromversorgung SV zur Spannungsversorgung von z.B. internen Steuer- und/oder Signaleinheiten vorhanden ist, wird auch zur Spannungsversorgung des Differenzverstärkers DIF bzw. als Betriebsspannung U_{H} für den Differenzverstärker DIF genutzt wird. Weiterhin weist der Differenzverstärker DIF eine Anbindung an ein Bezugs- oder Massepotential M auf.

Weiterhin umfasst die erfindungsgemäße Schaltungsanordnung ME einen Inverter INV, welcher ebenfalls die interne Hilfsspannung U_{H} zur Spannungsversorgung bzw. als Betriebsspannung benutzt und auch eine Anbindung an das Bezug- oder Massepotential M aufweist. Vom Inverter INV wird das vom Differenzverstärker DIF erzeugte Nutzsignal NS in ein invertiertes Nutzsignal negNS umgesetzt.

An einer Ausgangsseite des Inverters INV ist eine zweite Gleichrichtereinheit GL2, insbesondere ein Einweggleichrichter GL2 oder eine Gleichrichterdiode GL2, angebracht, von welcher das vom Inverter INV erzeugte, invertierte Nutzsignal negNS gleichgerichtet wird und zur Mischeinheit MS weitergeführt wird. Der zweiten Gleichrichtereinheit GL2 ist ebenfalls eine zweite Kompensationsdiode K2 zugeordnet, von welcher eine durch die Flussspannung der zweiten Gleichrichtereinheit GL2 verursachte Spannungsverschiebung kompensiert wird. Idealerweise sind auch die zweite Gleichrichtereinheit GL2 und die zweite Kompensationsdiode K2 als so genannte Doppeldiode ausgestaltet. Die zweite Gleichrichtereinheit GL2 und die zweite Kompensationsdiode K2 sind ebenfalls in einem gemeinsamen Gehäuse angeordnet und damit dadurch thermisch gekoppelt, wodurch temperaturabhängige Flussspannungen sehr einfach und gut eliminierbar sind.

Der zweiten Kompensationsdiode K2 sowie der zweiten Gleichrichtereinheit GL2 sind jeweils ein zweiter und ein dritter Pullup-Widerstand R4, R5 zugeordnet. Die zweite Pullup-Widerstand R4 ist zwischen der Anode der zweiten Kompensationsdiode K2 und der Hilfsversorgung U_{H} angeordnet. Der dritte Pullup-Widerstand R5 ist zwischen der Anode der zweiten Gleichrichtereinheit GL2 und der Hilfsversorgung U_{H} angebracht.

Um beispielsweise eine negative Betriebsspannung -U_{H} für den Differenzverstärker DIF bzw. für den Inverter INV einzusparen bzw. die interne Hilfsversorgung U_{H} der Stromversorgung SV nutzen zu können, ist weiterhin eine Referenzspannung Uref (z.B. 5V) vorgesehen.

In der Mischeinheit MS wird dann das Nutzsignal NS des Differenzverstärkers DIF und das invertierte Nutzsignal negNS des Inverters INV zu einem ersten Ausgangssignal AS1 zusammengeführt, welches beispielsweise für eine Bestimmung einer Spannungsart der Eingangsspannung Ue verwendet werden kann. D.h. aus dem ersten Ausgangssignal AS1 kann abgeleitet werden, ob es sich bei der Eingangsspannung Ue um eine Wechsel- oder Gleichspannung handelt.

Weiterhin weist die Schaltungsanordnung ME eine Filtereinheit auf. Die Filtereinheit ist z.B. als RC-Filter ausgestaltet und umfasst einen Widerstand R_{F} und eine Kapazität C_{F}. Mit Hilfe der Filtereinheit kann dem ersten Ausgangssignal AS1 ein zweites Ausgangssignal AS2 erzeugt werden, welcher z.B. einen Mittelwert des ersten Ausgangssignals AS1 darstellt. Das zweite Ausgangssignal AS2 kann beispielsweise für eine relativ genaue Bestimmung der Eingangsspannung Ue bzw. eines Eingangsspannungsmittelwert verwendet werden.

Das erste Ausgangssignal AS1 wie das zweite Ausgangssignal AS2 können dann z.B. über eine Datenverbindung (z.B. Profinet, etc.) an eine lokale oder zentrale Steuereinheit SE weitergeleitet werden, mit deren Hilfe die Ausgangssignale AS1, AS2 entsprechend ausgewertet werden können.

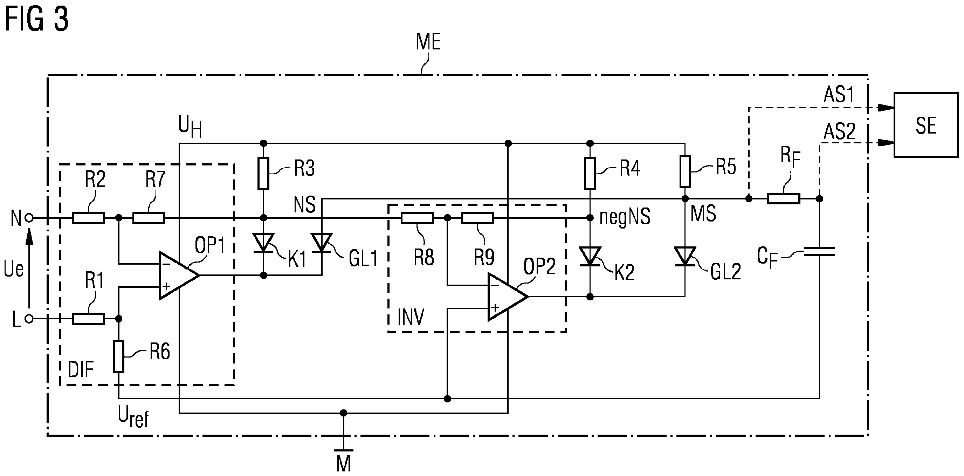

In Figur 3 ist ebenfalls beispielhaft und schematisch die erfindungsgemäße Schaltungsanordnung ME zum Auswerten der Eingangsspannung Ue der Stromversorgung SV dargestellt, wobei aus Figur 3 vor allem beispielhafte Ausführungsformen des Differenzverstärkers DIF bzw. des Inverters INV ersichtlich sind.

Der Differenzverstärker DIF der Schaltungsanordnung ME kann beispielsweise als Operationsverstärkerschaltung ausgeführt sein. Dazu umfasst der Differenzverstärker DIF einen Operationsverstärker OP1, welcher als positive Betriebsspannung z.B. die Hilfsspannung U_{H} nutzt und dessen negativer Betriebsspannungsanschluss mit dem Bezugs- oder Massepotential M verbunden ist. Weiterhin umfasst der Differenzverstärker DIF eingangsseitig zwei Eingangswiderstände R1, R2, welche hochohmig ausgeführt sind und z.B. einen gleichen Widerstandswert aufweisen. Es sind weiterhin zwei weitere Widerstände R6, R7 vorgesehen, welche im Vergleich zu den Eingangswiderständen R1, R2 niederohmig ausgeführt sind und z.B. ebenfalls den gleichen Widerstandswert aufweisen können. Dabei ist der erste Widerstand R6 des Differenzverstärkers DIF mit der Referenzspannung Uref verbunden und der zweite Widerstand R7 in der Rückkopplung des Differenzverstärkers DIF angeordnet. Ausgangsseitig des Differenzverstärkers DIF bzw. des Operationsverstärkers OP1 des Differenzverstärkers DIF ist wieder die erste Gleichrichtereinheit GL1 sowie in der Rückkopplung der Differenzverstärkerschaltung DIF die erste Kompensationsdiode K1 angeordnet.

Wie in Figur 3 beispielhaft dargestellt, kann auch der Inverter INV als Operationsverstärkerschaltung mit einem Operationsverstärker OP2 ausgestaltet sein. Auch der Operationsverstärker OP2 nutzt als positive Betriebsspannung z.B. die Hilfsspannung U_{H} und sein negativer Betriebsspannungsanschluss ist mit dem Bezugs- oder Massepotential M verbunden. Ein positiver Eingang des Operationsverstärkers OP2 des Inverters INV ist z.B. mit der Referenzspannung Uref verbunden. Über einen ersten Widerstand R8 des Inverters INV wird das vom Differenzverstärker DIF erzeugte Nutzsignal NS einem negativen Eingang des Operationsverstärkers OP2 des Inverters INV zugeführt. In der Rückkopplung des Operationsverstärkers OP2 des Inverters INV ist ein zweiter Widerstand R9 des Inverters INV angebracht, wobei für eine Invertierung des Nutzsignals NS die beiden Widerstände R8, R9 des Inverters INV den gleichen Widerstandswert aufweisen. Ausgangsseitig des Inverters INV bzw. des Operationsverstärkers OP2 ist die zweite Gleichrichtereinheit GL2 zum Gleichrichten des invertierten Nutzsignals negNS angeordnet sowie die zweite Kompensationsdiode in der Rückkopplung der Inverterschaltung INV.

Das gleichgerichtete Nutzsignal NS aus dem Differenzverstärker DIF und das gleichgerichtete, invertierte Nutzsignal NS werden wieder der Mischeinheit MS zugeführt und zum ersten Ausgangssignal AS1 gemischt. Über die RC-Filtereinheit R_{F}, C_{F} wird dann auch dem ersten Ausgangssignal AS1 das zweite Ausgangssignal AS2 abgeleitet.

Figur 4 zeigt beispielhaft einen zeitlichen Verlauf eines von der erfindungsgemäßen Schaltungsanordnung ME generierten, ersten Ausgangssignals AS1, von welchem gemäß dem erfindungsgemäßen Verfahren eine Spannungsart abgeleitet wird.

Auf einer waagrechten Achse ist dabei eine Zeit t aufgetragen und auf einer senkrechten Achse eine Spannung -U. Ein Schnittpunkt der senkrechten Achse mit der waagrechten Achse liegt auch auf einem Spannungswert der Referenzspannung Uref (z.B. bei 5V). Weiterhin sind auf der senkrechten Achse strichlierte Markierungen für 0 Volt, für einen ersten Schwellwert SW1 und einen zweiten Schwellwert SW2 aufgetragen, wobei der erste Schwellwert SW1 näher beim Wert Referenzspannung Uref liegt als der zweite Schwellwert SW2. Alternativ kann auch ein Schwellwert mit einer Hysterese verwendet werden. Das erste Ausgangssignal AS1 weist aufgrund der Gleichrichtung durch die beiden Gleichrichtereinheiten GL1, GL2 der Schaltungsanordnung ME beispielsweise einen zeitlichen Verlauf einer pulsierenden Gleichspannung auf, wobei eine Welle einen Scheitelwert Û aufweist.

Für die Auswertung der Eingangsspannung Ue bzw. des ersten Ausgangssignals AS1 wird nach Beginn des erfindungsgemäßen Verfahrens zuerst ein einmaliges Durchlaufen des Scheitelwertes Û des ersten Ausgangssignals abgewartet. Vom Scheitelwert Ü kommend wird dann ein Unterschreiten des ersten Schwellwertes SW1 abgewartet. Wird ein Unterschreiten des ersten Schwellwerts SW1 beispielsweise an einem ersten Zeitpunkt t1 festgestellt, so wird ein erster Zeitstempel abgespeichert und eine vorgegebenen Totzeit Tₜ gestartet. Nach Ablauf der vorgegebenen Totzeit Tₜ zu einem zweiten Zeitpunkt t2 wird geprüft bzw. gewartet, bis der zweite Schwellwert SW2 überschritten wurde. Nach Überschreiten des zweiten Schwellwerts SW2 wird gewartet, wann das erste Ausgangssignal AS1 wieder den ersten Schwellwert SW1 unterschreitet. Wird zu einem dritten Zeitpunkt t3 der erste Schwellwert SW1 wieder unterschritten, so wird wieder ein zweiter Zeittempel abgespeichert und die vorgegebenen Totzeit Tₜ gestartet. Nach Ablauf der Totzeit Tₜ zu einem vierten Zeitpunkt t4 wird wieder geprüft, ob der zweite Schwellwert SW2 überschritten wurde. Ist dies der Fall, so wird wieder auf das Unterschreiten des ersten Schwellwerts SW1 gewartet und ein Zeitstempel abgespeichert, wenn zu einem fünften Zeitpunkt t5 das Unterschreiten des ersten Schwellwerts SW1 durch das erste Ausgangssignal AS1 festgestellt wird.

Die Schritte "Abspeichern eines Zeitstempels und Starten einer vorgegebenen Totzeit Tₜ, wenn der erste Schwellwert SW1 vom ersten Ausgangssignal AS1 unterschritten wird", "Prüfen, ob nach Ablauf der vorgegebenen Totzeit Tₜ ein zweiter Schwellwert SW2 vom ersten Ausgangssignal (AS1) überschritten wird" und "Abwarten bis das erste Ausgangssignal AS1 den ersten Schwellwert SW1 wieder unterschreitet, nachdem bei oder nach Ablauf der Totzeit Tₜ der zweite Schwellwert SW2 vom ersten Ausgangssignal AS1 überschritten wurde" werden solange wiederholt, bis eine vorgegebene Anzahl an Wiederholungen - z.B. 10 Wiederholungen - erreicht ist. Danach kann aus zumindest zwei gespeicherten Zeitstempeln eine Frequenz des ersten Ausgangssignals AS1 und damit der Eingangsspannung Ue abgeleitet werden. Liegt diese Frequenz beispielsweise in einem Bereich von 45 bis 65 Hertz, so kann die Eingangsspannung Ue als Wechselspannung bewertet werden.

Wird nach Ablauf der Totzeit Tt der zweite Schwellwert SW2 innerhalb einer vorgebbaren ersten Zeitdauer (z.B. 100ms) nie überschritten bzw. wird nach Ablauf einer zweiten Zeitdauer beispielsweise nach einem erstmaligen Durchlaufen des Scheitelwerts Û des ersten Ausgangssignals AS1 der erste Schwellwert SW1 nie unterschritten, so kann eine Durchführung des Verfahrens abgebrochen bzw. die Eingangsspannung Ue als Gleichspannung bewertet. Weiterhin kann die Eingangsspannung Ue auch als Gleichspannung gewertet werden, wenn sich aus den gespeicherten Zeitstempeln z.B. nach der vorgegebenen Anzahl an Wiederholungen der Verfahrensschritt keine Frequenz des ersten Ausgangssignals AS1 detektieren lässt. Das Verfahren zur Auswertung einer Eingangsspannung Ue einer Stromversorgung wird beispielsweise in der Steuereinheit SE durchgeführt. Die Auswertung des ersten wie des zweiten Ausgangssignals können dann beispielsweise an eine lokale oder zentrale Steuer-, Auswerte- und/oder Anzeigeeinheit weitergeleitet werden, um z.B. angezeigt zu werden oder entsprechend weiterverarbeitet zu werden.

## Patentansprüche

1. Verfahren zum Ermitteln einer Spannungsart einer Eingangsspannung (Ue) einer Stromversorgung wobei ein auf der Eingangsspannung (Ue) der Stromversorgung (SV) basierendes erstes Ausgangsignal (AS1) mit einer Schaltungsanordnung (ME) erfasst wird, wobei nach erstmaligem Durchlaufen eines Scheitelwertes (Ü) des ersten Ausgangssignal (Ue) abgewartet wird, dass ein erster Schwellwert (SW1) unterschritten wird, und wobei dann folgende Schritte bis zum Erreichen einer vorgegebenen Anzahl an Wiederholungen durchlaufen werden:
- Abspeichern eines Zeitstempels und Starten einer vorgegebenen Totzeit (Tₜ), wenn der erste Schwellwert (SW1) vom ersten Ausgangssignal (AS1) unterschritten wird;
- Prüfen, ob nach Ablauf der vorgegebenen Totzeit (Tₜ) ein zweiter Schwellwert (SW2) vom ersten Ausgangssignal (AS1) überschritten wird; und
- Abwarten bis das erste Ausgangssignal (AS1) den ersten Schwellwert wieder unterschreitet, wenn bei Ablauf der Totzeit (Tₜ) der zweite Schwellwert (SW2) vom ersten Ausgangssignal (AS1) überschritten wurde, wobei der zweite Schwellwert (SW2) größer als der erste Schwellwert (SW1) ist;
und wobei nach Erreichen der vorgegebenen Anzahl an Wiederholungen aus den gespeicherten Zeitstempeln eine Frequenz und die Spannungsart der Eingangsspannung (Ue) abgeleitet wird.

2. Verfahren nach Anspruch 1 ***wobei*** das Verfahren abgebrochen wird, wenn nach Ablauf der Totzeit (Tt) der zweite Schwellwert (SW2) innerhalb einer vorgebbaren ersten Zeitdauer nicht überschritten wird.

3. Verfahren nach einem der Ansprüche 1 bis 2, ***wobei*** das Verfahren abgebrochen wird, wenn nach Ablauf einer zweiten vorgebbaren Zeitdauer der erste Schwellwert (SW1) nicht unterschritten wird.

4. Schaltungsanordnung welche zur Durchführung eines Verfahrens nach einem der Ansprüche 1 bis 3 eingerichtet ist, **dadurch gekennzeichnet, dass** die Schaltungsanordnung (ME) zumindest umfasst:
- einen Differenzverstärker (DIF), eine erste Gleichrichtereinheit (GL1) und eine erste Kompensationsdiode (K1), wobei der Differenzverstärker eingerichtet ist zum Umwandeln der Eingangsspannung (Ue) in ein Nutzsignal (NS), welches über die erste Gleichrichtereinheit (GL1) gleichgerichtet wird, die an einem Ausgang des Differenzverstärkers (DIF) angeordnet ist und der die erste Kompensationsdiode (K1) zugeordnet ist;
- einen Inverter (INV), eine zweite Gleichrichtereinheit (GL2) und eine zweite Kompensationsdiode (K2), wobei der Inverter (INV) eingerichtet ist zum Erzeugen eines invertierten Nutzsignals (negNS) aus dem Nutzsignal (NS), wobei das invertierte Nutzsignal (negNS) über die zweite Gleichrichtereinheit (GL2) gleichgerichtet wird, die an einem Ausgang des Inverters (INV) angeordnet ist und der die zweite Kompensationsdiode (K2) zugeordnet ist, und
- eine Mischeinheit (MS)eingerichtet zum Erzeugen eines ersten Ausgangssignal (AS1) aus dem gleichgerichteten Nutzsignal (NS) und dem gleichgerichteten, invertierten Nutzsignal (negNS) derart, dass das erste Ausgangssignal (AS1) für eine Bestimmung der Spannungsart der Eingangsspannung (Ue) verwendbar ist; und
- eine Steuereinheit (SE) eingerichtet das Verfahren zum Ermitteln der Spannungsart nach einem der Ansprüche 1-3 durchzuführen.

## Claims

1. Method for ascertaining a voltage type of an input voltage (Ue) of a power supply, wherein a first output signal (AS1) based on the input voltage (Ue) of the power supply (SV) is detected using a circuit arrangement (ME),
wherein, after a peak (Û) of the first output signal (Ue) is passed through for the first time, the method waits for a first threshold value (SW1) to be undershot, and wherein the following steps are then run through until a predetermined number of repetitions is reached:
- storing a time stamp and starting a predetermined dead time (Tₜ) when the first output signal (AS1) undershoots the first threshold value (SW1);
- checking whether the first output signal (AS1) exceeds a second threshold value (SW2) after the predetermined dead time (Tₜ) has elapsed; and
- waiting until the first output signal (AS1) undershoots the first threshold value again when the first output signal (AS1) has exceeded the second threshold value (SW2) when the dead time (Tₜ) has elapsed, wherein the second threshold value (SW2) is greater than the first threshold value (SW1);
and wherein a frequency and the voltage type of the input voltage (Ue) is derived from the stored time stamps after the predetermined number of repetitions has been reached.

2. Method according to Claim 1, wherein the method is terminated when the second threshold value (SW2) is not exceeded within a predeterminable first period after the dead time (Tₜ) has elapsed.

3. Method according to one of Claims 1 to 2, wherein the method is terminated when the first threshold value (SW1) is not undershot after a second predeterminable period has elapsed.

4. Circuit arrangement, which is set up to carry out a method according to one of Claims 1 to 3, **characterized in that** the circuit arrangement (ME) at least comprises:
- a differential amplifier (DIF), a first rectifier unit (GL1) and a first compensation diode (K1), wherein the differential amplifier is set up to convert the input voltage (Ue) into a useful signal (NS), which is rectified by means of the first rectifier unit (GL1) which is arranged at an output of the differential amplifier (DIF) and to which the first compensation diode (K1) is assigned;
- an inverter (INV), a second rectifier unit (GL2) and a second compensation diode (K2), wherein the inverter (INV) is set up to generate an inverted useful signal (negNS) from the useful signal (NS), wherein the inverted useful signal (negNS) is rectified by means of the second rectifier unit (GL2) which is arranged at an output of the inverter (INV) and to which the second compensation diode (K2) is assigned, and
- a mixer unit (MS), which is set up to generate a first output signal (AS1) from the rectified useful signal (NS) and the rectified inverted useful signal (negNS) in such a way that the first output signal (AS1) can be used to determine the voltage type of the input voltage (Ue); and
- a control unit (SE), which is set up to carry out the method for ascertaining the voltage type according to one of Claims 1-3.

## Revendications

1. Procédé pour déterminer un type de tension d'une tension d'entrée (Ue) d'une alimentation électrique, dans lequel un premier signal de sortie (AS1) basé sur la tension d'entrée (Ue) de l'alimentation électrique (SV) est détecté à l'aide d'un agencement de circuit (ME),
dans lequel est attendu, après le premier passage d'une valeur de crête (U) du premier signal de sortie (Ue), le dépassement d'une première valeur de seuil (SW1), et dans lequel les étapes suivantes sont ensuite exécutées jusqu'à ce qu'un nombre prédéfini de répétitions soit atteint :
- mémoriser un horodatage et démarrer un temps mort prédéfini (Tₜ) si la première valeur de seuil (SW1) est inférieure au premier signal de sortie (AS1) ;
- vérifier qu'une deuxième valeur de seuil (SW2) est dépassée par le premier signal de sortie (AS1) après l'expiration du temps mort prédéfini (Tₜ) ; et
- attendre que le premier signal de sortie (AS1) revienne en dessous de la première valeur de seuil si, à l'expiration du temps mort (Tₜ), la deuxième valeur de seuil (SW2) a été dépassée par le premier signal de sortie (AS1), la deuxième valeur de seuil (SW2) étant supérieure à la première valeur de seuil (SW1) ;
et dans lequel
après avoir atteint le nombre prédéfini de répétitions, la fréquence et le type de tension de la tension d'entrée (Ue) sont dérivés des horodatages stockés.

2. Procédé selon la revendication 1, dans lequel le procédé est interrompu si, après l'expiration du temps mort (Tₜ), la deuxième valeur de seuil (SW2) n'est pas dépassée pendant une première période de temps prédéfinissable.

3. Procédé selon l'une quelconque des revendications 1 à 2, dans lequel le procédé est interrompu si la première valeur de seuil (SW1) n'est pas dépassée après l'expiration d'une deuxième période de temps prédéfinissable.

4. Agencement de circuit conçu pour exécuter un procédé selon l'une quelconque des revendications 1 à 3, **caractérisé en ce que** l'agencement de circuit (ME) comprend au moins :
- un amplificateur différentiel (DIF), une première unité de redressement (GL1) et une première diode de compensation (K1), l'amplificateur différentiel étant conçu pour convertir la tension d'entrée (Ue) en un signal utile (NS) qui est redressé par l'intermédiaire de la première unité de redressement (GL1) qui est agencée sur une sortie de l'amplificateur différentiel (DIF) et à laquelle est associée la première diode de compensation (K1) ;
- un inverseur (INV), une deuxième unité de redressement (GL2) et une deuxième diode de compensation (K2), l'inverseur (INV) étant conçu pour générer un signal utile inversé (negNS) à partir du signal utile (NS), le signal utile inversé (negNS) étant redressé par l'intermédiaire de la deuxième unité de redressement (GL2) qui est agencée sur une sortie de l'inverseur (INV) et à laquelle est associée la deuxième diode de compensation (K2), et
- une unité de mélange (MS) conçue pour générer un premier signal de sortie (AS1) à partir du signal utile redressé (NS) et du signal utile inversé redressé (negNS) de telle sorte que le premier signal de sortie (AS1) puisse être utilisé pour déterminer le type de tension de la tension d'entrée (Ue) ; et
- une unité de commande (SE) conçu pour effectuer le procédé de détermination du type de tension selon l'une quelconque des revendications 1 à 3.
